(19) Europäisches Patentamt
European Patent Office
Office européen des brevets

(11) **EP 3 835 800 B1**

(12) **FASCICULE DE BREVET EUROPEEN**

(45) Date de publication et mention
de la délivrance du brevet:
**28.02.2024 Bulletin 2024/09**

(21) Numéro de dépôt: **20208543.7**

(22) Date de dépôt: **19.11.2020**

(51) Classification Internationale des Brevets (IPC):
**G01R 31/36** (2020.01)    **G01R 31/3842** (2019.01)
**G01R 31/392** (2019.01)

(52) Classification Coopérative des Brevets (CPC):
**G01R 31/3648; G01R 31/3842; G01R 31/392;**
Y02E 60/10

(54) **DIAGNOSTIC DE SYSTÈMES DE STOCKAGE D'ÉNERGIE EN OPÉRATION**

DIAGNOSE VON ENERGIESPEICHERSYSTEMEN IN BETRIEB

DIAGNOSIS OF ENERGY STORAGE SYSTEMS IN OPERATION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.12.2019 FR 1914139**

(43) Date de publication de la demande:
**16.06.2021 Bulletin 2021/24**

(73) Titulaire: **Electricité de France**
**75008 Paris (FR)**

(72) Inventeurs:
• **LANCEL, Gilles**
**94230 CACHAN (FR)**
• **BRUN, Emeric**
**77210 AVON (FR)**

(74) Mandataire: **Plasseraud IP**
**66, rue de la Chaussée d'Antin**
**75440 Paris Cedex 09 (FR)**

(56) Documents cités:
**US-A1- 2013 311 118     US-A1- 2015 293 183
US-A1- 2018 050 681     US-A1- 2019 004 115**

**Description**

**Domaine technique**

L'invention relève du domaine des dispositifs électrochimiques de stockage d'énergie, et plus particulièrement du diagnostic de batteries, ou accumulateurs.

**Technique antérieure**

Il est connu de modéliser les pertes de performances des batteries au fil du temps en fonction de leur utilisation. Cela implique de suivre les divers paramètres de l'utilisation et reste dans tous les cas théorique : l'état réel de la batterie à un instant donné reste inconnu.

Il est aussi possible de mesurer certaines propriétés d'une batterie pour en déduire son état. L'un des paramètres de performance d'un dispositif électrochimique est une variable appelée « état de santé », ou SOH pour « *State Of Health* ». Ce paramètre, sans unité et exprimé généralement en pourcentage, se définit comme le rapport de la capacité électrique réelle $C_{rea}$ de l'élément testé sur la capacité électrique nominale $C_{nom}$ du même élément. L'équation ci-après représente ce paramètre :

[Math. 1]

$$SOH = \frac{C_{rea}}{C_{nom}} \times 100$$

Un autre paramètre utile à la qualification d'un état d'un dispositif électrochimique est « l'état de charge », ou SOC pour « State Of Charge ». Ce paramètre est aussi sans unité et exprimé généralement en pourcentage. Le SOC se définit comme le rapport de la charge réelle disponible $Q_t$ de l'élément testé sur la charge maximale $Q_{max,t}$ du même élément dans son état de santé actuel. L'équation ci-après représente ce paramètre :

[Math. 2]

$$SOC = \frac{Q_t}{Q_{max,t}} \times 100$$

Il est possible de mesurer des propriétés d'un élément électrochimique relatives à son état de santé. Généralement, cela nécessite de lui imposer des sollicitations particulières (cycles de caractérisation). Cela nécessite des équipements de contrôle particuliers et du temps. Les méthodes connues tendent même à dégrader les éléments testés et leur état de santé que l'on souhaite justement évaluer. De manière générale, un élément électrochimique soumis à de tels essais n'est plus opérationnel le temps des essais. Autrement dit, cela est réalisé au cours d'une période de maintenance.

Enfin, quelques méthodes peuvent être mises en oeuvre pendant une phase opérationnelle du dispositif mais seulement dans certaines conditions de fonctionnement, par exemple lorsque la charge et/ou la décharge est complète. D'autres impliquent que des opérateurs entrent des données autres que des données de mesure du dispositif.

Les documents suivant traitent de tels sujets : WO 2019/025171, WO 2015/133103, WO 2013/111231, WO 2015/186283, FR 3003038, WO 2011 /1555184, US 2018/050681 A1.

La présente divulgation vient améliorer la situation.

Il est proposé un procédé de détermination d'une tension à vide d'un dispositif électrochimique, mis en oeuvre par des moyens informatiques, comprenant :

  a. collecter des données de mesures du dispositif, lesdites mesures

    i. incluant au moins le courant $I_t$ et la tension $U_t$ aux bornes du dispositif,
    ii. étant horodatées, et
    iii. étant acquises aux cours d'une période de fonctionnement opérationnel et ininterrompue du dispositif ;

  b. calculer, pour une pluralité d'instants t,

iv. une intensité corrigée $I_{cor,t}$ par l'application d'une fonction de correction à l'intensité mesurée $I_t$, et

v. une charge instantanée $Q_t$ à partir d'une série temporelle de l'intensité corrigée $I_{cor}$

de manière à obtenir, pour chaque instant t, un jeu de données collectées et calculées $I_t$, $U_t$, $I_{cor,t}$, $Q_t$ ;

c. grouper les jeux de données par plages de valeurs de charge instantanée en fonction de ladite valeur de charge de chaque jeu ;

d. pour chaque groupe distinctement, calculer une tension à vide du dispositif.

Selon un autre aspect, il est proposé un programme informatique comportant des instructions pour la mise en oeuvre de tout ou partie d'un procédé tel que défini dans les présentes lorsque ce programme est exécuté par un processeur. Selon un autre aspect, il est proposé un support d'enregistrement non transitoire, lisible par un ordinateur, sur lequel est enregistré un tel programme.

Les caractéristiques exposées dans les paragraphes suivants peuvent, optionnellement, être mises en oeuvre. Elles peuvent être mises en oeuvre indépendamment les unes des autres ou en combinaison les unes avec les autres :

Le procédé comprend en outre, après le calcul des tensions à vide :

e. calculer un état de santé du dispositif selon la formule suivante :

[Math. 7]

$$SOH = \frac{Q_{1\to2,\text{agé}}}{Q_{1\to2,\text{init}}}$$

dans laquelle $Q_{1\to2,\text{agé}}$ correspond à la différence de charge Q entre deux jeux de données correspondant à deux tensions à vide $COV_1$ et $COV_2$ et dans laquelle $Q_{1\to2,\text{init}}$ correspond à la charge Q échangée entre les deux tensions à vide $COV_1$ et $COV_2$ dans un état initial du dispositif pour lequel l'état de santé est considéré être maximal.

Le procédé comprend en outre, après le calcul des tensions à vide :

f. soumettre les tensions à vide calculées à une analyse de capacité incrémentielle (ICA) de manière à obtenir une courbe à motifs caractéristiques ;

g. comparer a courbe obtenue à des courbes de référence correspondant à divers états de santé afin d'identifier l'état de santé par correspondance.

Dans le procédé, l'étape de calcul est mise en oeuvre de manière itérative à chaque instant t et dans lequel le calcul de la charge instantané $Q_t$ à partir d'une série temporelle de l'intensité corrigée $I_{cor}$ est mis en oeuvre selon la formule suivante, dans laquelle Q(t=t0) est un niveau de charge relatif au niveau de charge initial :

[Math. 3]

$$Q(t) = Q(t = t_0) + \int_{t_0}^{t} I_{corr}(\tau)\, d\tau$$

Dans le procédé, l'étape de calcul comprend en outre : vi. calculer un état de charge (SOC) selon la formule suivante :

[Math. 8]

$$SOC_i = SOC_{i-1} + \frac{\int_{i-1}^{i} \alpha(I_i)\, dt}{Q_{max,i}} = SOC_{i-1} + \frac{\int_{i-1}^{i} I_{corr}\, dt}{Q_{max,i}}$$

où l'indice i représente l'itération et $\alpha$ la fonction de correction.

Le procédé comprend en outre, après le calcul des tensions à vide :

h. comparer les tensions à vide calculées à des courbes de correspondance entre tensions à vide et état de charge afin d'identifier l'état de charge par correspondance.

Le procédé comprend en outre, après le calcul des tensions à vide, un calcul d'état de santé du dispositif par l'une au moins des opérations suivantes :

- comparaison des tensions à vide obtenues avec des tensions à vide obtenues par des essais d'une pluralité de vieillissements en laboratoire sur ledit dispositif ;
- comparaison des tensions à vide obtenues avec des tensions à vide obtenues par des essais d'une pluralité de vieillissements en laboratoire sur un dispositif de modèle similaire audit dispositif ;
- comparaison des tensions à vide obtenues avec des tensions à vide obtenues par une mise en oeuvre antérieure du procédé selon la revendication 1 sur ledit dispositif.

Par modèle similaire, on entend ici un dispositif électrochimique présentant les mêmes matériaux que le dispositif étudié, en particulier pour les électrodes.

**Brève description des dessins**

D'autres caractéristiques, détails et avantages apparaîtront à la lecture de la description détaillée ci-après, et à l'analyse des dessins annexés, sur lesquels :

**Fig. 1**

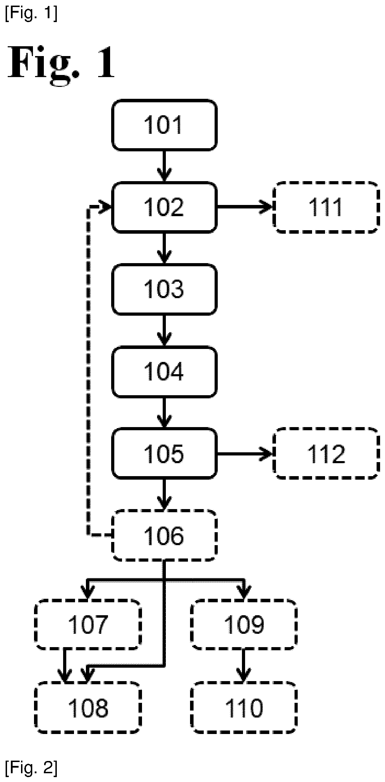

[Fig. 1] montre un diagramme d'un mode de réalisation d'un procédé.

**Fig. 2**

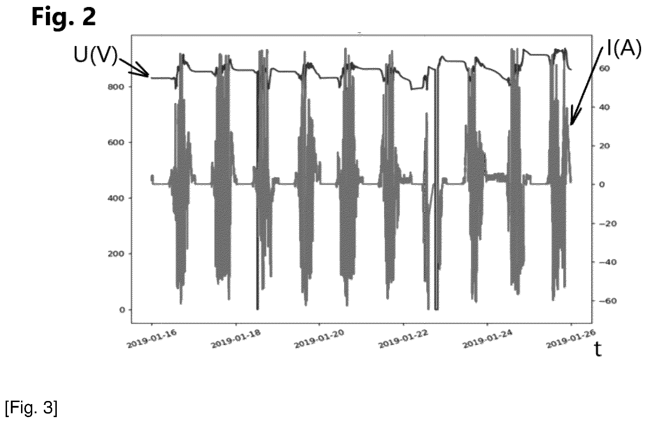

[Fig. 2] montre un graphique représentatif de séries temporelles utilisées en tant que données d'entrée d'un mode de réalisation d'un procédé.

**Fig. 3**

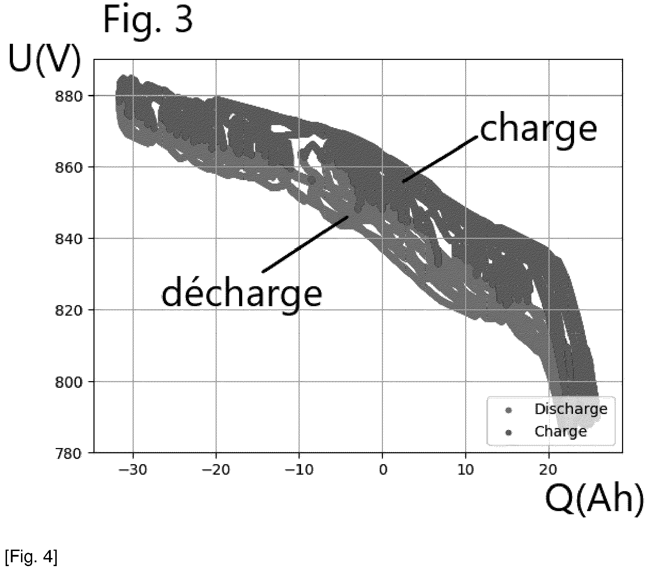

[Fig. 3] montre un graphique représentatif d'un comptage coulombique au cours de charges et décharges.

**Fig. 4**

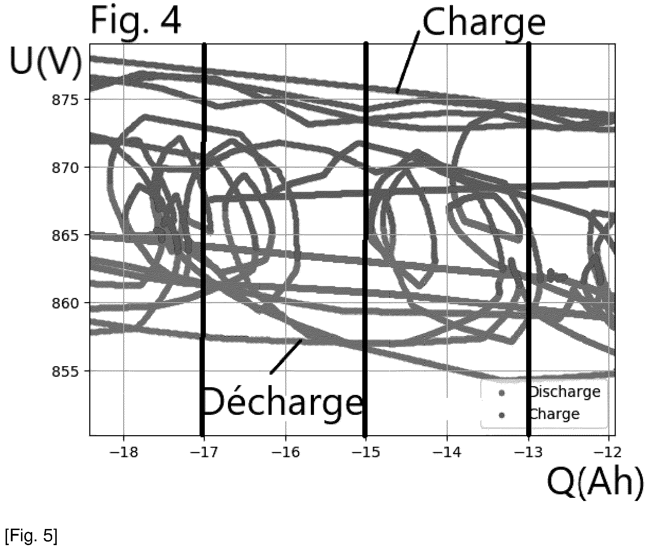

[Fig. 4] représente une étape de groupement par tranche de charge/décharge d'un mode de réalisation.

**Fig. 5**

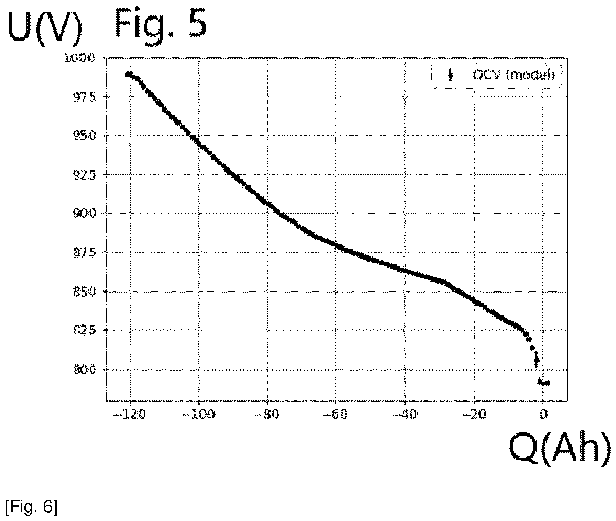

[Fig. 5] montre un exemple de résultat de courbe de tension à vide obtenue.

**Fig. 6**

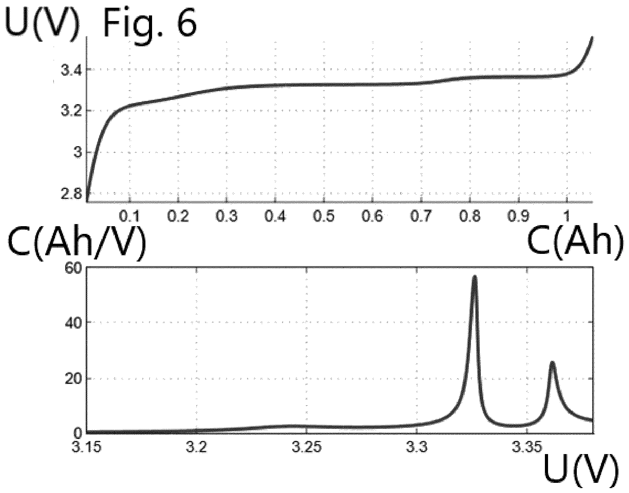

[Fig. 6] montre un exemple d'une étape d'un mode de réalisation par une analyse en composantes indépendantes (ICA).

**Description des modes de réalisation**

Les dessins et la description ci-après contiennent, pour l'essentiel, des éléments de caractère certain. Ils pourront donc non seulement servir à mieux faire comprendre la présente divulgation, mais aussi contribuer à sa définition, le cas échéant.

Un mode de réalisation d'un procédé de détermination d'une tension à vide d'un dispositif électrochimique va maintenant être décrit en référence à la [Fig. 1] et dans un premier temps sous la forme d'un premier ensemble d'opérations 101 à 106. Par dispositif électrochimique, on entend ici viser tout dispositif propre à stocker de l'énergie électrique sous forme chimique, typiquement des batteries ou accumulateurs.

Dans une première opération 101, des données de mesures du dispositif sont collectées. Les mesures incluent au moins le courant $I_t$ et la tension $U_t$ aux bornes du dispositif. En variante, d'autres mesures peuvent être collectées, notamment la température $T_t$. Les mesures sont horodatées. Cela signifie qu'elles peuvent être ensuite traitées en fonction de la date à laquelle elles ont été mesurées. Notamment, les données de différentes natures ayant la même date peuvent former ensemble un n-uplet, où n est le nombre de données par instant t.

Les données collectées sont acquises aux cours d'une période de fonctionnement opérationnel et ininterrompu du dispositif. Ainsi, chaque type de données prend la forme d'une série temporelle, ici de la tension et du courant du dispositif en fonctionnement opérationnel. On entend ici par fonctionnement opérationnel se distinguer d'une phase de maintenance ou d'essai pour laquelle les conditions de fonctionnement peuvent être choisies pour correspondre à des conditions d'essai. En fonctionnement opérationnel, au contraire, le dispositif suit des conditions de fonctionnement habituelles, non imposées spécifiquement pour les mesures.

Il est préférable que chaque série temporelle collectée soit exploitable. Aussi, l'opération de collecte 101 peut comprendre, ou être précédée d'une sélection, ou filtrage, éliminant de la collecte les séries temporelles incluant un pas de temps inutilisable, par exemple en cas d'absence de valeur, de message d'erreur, de mauvais alignement des mesure, etc. À l'issu de la sélection, les séries temporelles collectées sont toutes continues et exploitables.

La [Fig. 2] montre un exemple de séries temporelles pouvant servir de données d'entrée. La tension est indiquée en ordonnées à gauche et correspond à la courbe généralement située en partie supérieure tandis que le courant est indiqué en ordonnées à droite et correspond à la courbe présentant de grandes variations.

Dans une opération 102, une intensité corrigée $I_{cor,t}$ est calculée, à partir des données collectées à l'issue de l'opération 101 et pour une pluralité d'instants t. Le calcul de l'intensité corrigée $I_{cor,t}$ est réalisée par l'application d'une fonction de correction à l'intensité mesurée $I_t$. Dans la suite, la fonction de correction est notée $\alpha$ (alpha). Les paramètres de la fonction de correction $\alpha$ peuvent comprendre la température T, la charge Q et/ou la tension U.

L'application d'une fonction de correction $\alpha$ s'explique par les pertes électrochimiques : la charge entrée dans le dispositif lors de la charge n'est jamais totalement restituée lors de la décharge. Ce déséquilibre peut entrainer une dérive du calcul de l'état de charge instantané Q en l'absence de correction.

Dans une opération 103, un comptage coulombique est effectué. Une charge instantané $Q_t$ est calculée à partir de la série temporelle de l'intensité corrigée $I_{cor}$. La charge instantanée $Q_t$ est calculée pour une pluralité d'instants t.

La charge instantanée $Q_t$ est calculée par un calcul intégral selon la formule suivante :

[Math. 3]

$$Q(t) = Q\,(t = t_0) + \int_{t_0}^{t} I_{corr}(\tau)\, d\tau$$

Dans le cas où la charge initiale $Q(t=t_0)$ est inconnue, un niveau de charge relatif par rapport à la charge initiale est suffisant. Lorsque le calcul d'intégrale est implémenté dans un algorithme, il peut l'être sous une forme finie.

À l'issu de l'opération 103, à chaque instant t (ou pas de temps) est associé une intensité $I_t$, une intensité corrigée $I_{corr,t}$, un niveau de charge $Q_t$ et une tension $U_t$. Ainsi, pour chaque instant t, est obtenu un jeu de données collectées et calculées $I_t$, $U_t$, $I_{cor,t}$, $Q_t$.

La [Fig. 3] représente un comptage coulombique dans un graphique présentant la charge cumulée Q (en ampère-heure) en abscisses et la tension (en volt) en ordonnées. La partie supérieure de la courbe correspond à des phases de charge tandis que la partie inférieure de la courbe correspond à des phases de décharge.

Dans une opération 104, les jeux de données sont groupés par plages de valeurs de charge instantanée $Q_t$ en fonction de ladite valeur de charge de chaque jeu. Dit autrement, et contrairement à des méthodes connus, les données ne sont pas regroupées temporellement, par périodes de temps successives, mais par valeurs de charge instantanée, ici indépendamment de leur horodatage.

Par exemple, des plages de charge (ou « tranches ») sont déterminée et définissent les groupes. Dans l'exemple sous forme d'équation qui suit, les groupes sont définis par des plages de valeurs de charge centrées autour d'une valeur de charge de référence par groupe. Un groupe de charge j rassemble par exemple les pas de temps i selon la formule suivante :

[Math. 4]

$$j = \left\{ \left( I_i, I_{corr,i}, Q_i, U_i \right) \; tels \; que \; \left| Q_{ref} - Q_i \right| < \varDelta Q \right\}$$

Dans l'exemple ci-avant, les groupes sont tous définis avec une amplitude de charge similaire ($2*\Delta Q$). En variante, les amplitudes peuvent être hétérogènes entre les groupes.

Au cours du fonctionnement du dispositif, une succession d'états peuvent être atteints. Le dispositif peut donc se trouver dans deux états similaires à plusieurs moments sans pour autant que ces moments soient successifs. L'état de charge pouvant en première approximation être considéré comme caractérisant l'état du dispositif, l'ensemble des instants (ou pas de temps) présentant une charge Q similaire peuvent donc être considérés comme correspondant à des états électrochimiques similaires.

La [Fig. 4] représente un détail de la courbe de la [Fig. 3] sur laquelle le « découpage » en groupes de charges est représenté par des segments verticaux.

Dans une opération 105, une tension à vide du dispositif est calculée pour chaque groupe distinctement (ou tranche par tranche).

De nombreux modèles permettent d'estimer la tension à vide (ou OCV pour « *Open Circuit Voltage* ») à partir des séries temporelles en courant et tension.

Les méthodes connues sont appliquées par pas de temps ou sur un ensemble consécutif de pas de temps. Ici, l'estimation est effectuée sur un ensemble de pas de temps distincts et potentiellement éloignés dans le temps. Par exemple, un modèle électrique équivalent du premier ordre peut être utilisé selon l'équation suivante.

[Math. 5]

$$U(t) = Voc(t) + R * I(t)$$

Ici, la notion de temps disparait au profit de la notion d'état de charge. Le calcul par pas de temps usuel est remplacé par un calcul par groupe ou plage de charges ou encore par tranche. Le calcul de la tension à vide (notée $V_{oc}$ dans l'équation) s'effectue par l'application d'une fonction de minimisation des écarts avec un modèle. En prenant un exemple d'une minimisation par les moindres carrés, la tension à vide estimée pour un groupe respecte la formule suivante :

[Math. 6]

$$(Voc, R) \text{ tels que } \sum_i (U_i - Voc - R\,I_i)^2 = min\left(\sum_i (U_i - a - b\,I_i)^2\right) = \Delta$$

Le minimum $\Delta$, aussi appelé résidu, de la fonction des moindres carrés est représentatif de la robustesse du couple ($V_{oc}$, R) obtenu. Il peut être utilisé pour ajuster la fonction de correction $\alpha$ comme cela sera décrit plus en détail ci-après.

À l'issu des calculs de tensions à vide pour chacun des groupes, on dispose d'un ensemble de couples ($Q_{ref}$, $V_{oc}$), c'est-à-dire une estimation de la courbe caractéristique de tension à vide OCV.

Une opération 106, optionnelle, peut être mise en oeuvre. L'opération 106 comprend la représentation graphique des couples ($Q_{ref}$, $V_{oc}$). La [Fig. 6] est un exemple d'une telle représentation : une courbe de tension à vide du dispositif.

Les opérations 101 à 106 décrites ci-avant peuvent être vues comme formant un premier ensemble. Ce premier ensemble peut être résumé par le pseudocode suivant :

*Identification des périodes continues*
*Tant que l'erreur est insatisfaisante :*

   *Pour chaque période continue :*

     *Tant que l'erreur est insatisfaisante :*

       *Mise à jour de la fonction de correction*
       *Application de la fonction de correction au courant*
       *Comptage coulombique*
       *Découpage en tranches d'état de charge similaires*
       *Pour chaque tranche :*

         *Calcul de minimisation*
         *Obtention de $V_{oc}$ (et autres paramètres d'intérêt)*

       *Vérification de l'erreur*

    *Obtention de la courbe OCV (et autres paramètres d'intérêt) pour cette période*

*Obtention de la courbe OCV (et autres paramètres d'intérêt) pour chacune des périodes identifiées.*

Le premier ensemble d'opérations 101 à 106 permet une estimation vraisemblable de l'état du dispositif car basée sur les postulats suivants :

- L'état électrochimique d'un élément électrochimique peut, au premier ordre, être caractérisé par sa tension de circuit ouvert, qui est elle-même uniquement fonction de la charge Q contenue dans l'élément. Toute choses égales par ailleurs, à chaque niveau de charge Q correspond une unique tension de circuit ouvert et *vice versa* (bijection).
- Il est possible d'estimer la tension de circuit ouvert à partir de la tension totale U et de l'intensité I par l'utilisation de modèles mathématiques, électrochimiques et/ou électriques.

Les données mesurées en opération donnent accès à la tension totale en charge U aux bornes du dispositif et à l'intensité I le traversant. Par un calcul intégral, il est possible de transformer l'évolution de l'intensité I traversant le dispositif en évolution de son niveau de charge Q. Ainsi, pour chaque pas de temps, il est possible d'obtenir, au moins, les triplets I, Q, U. Or, à chaque niveau de charge Q correspond une unique tension à vide $V_{oc}$. De plus, on connait une relation entre I, U et $V_{oc}$. À partir des triplets (I, Q, U) tels que les Q sont proches, il est possible d'identifier une unique valeur de $V_{oc}$ satisfaisant des conditions de précision préétablies.

Les opérations qui vont maintenant être décrites permettent, à partir des courbes OCV obtenues ci-avant, d'estimer en outre l'état de santé SOH du dispositif.

Dans une opération 108, un état de santé du dispositif est calculé selon la formule suivante :

[Math. 7]

$$SOH = \frac{Q_{1 \to 2, \text{agé}}}{Q_{1 \to 2, \text{init}}}$$

$Q_{1 \to 2, \text{agé}}$ correspond à la différence de charge Q entre deux jeux de données correspondant à deux tensions à vide $COV_1$ et $COV_2$. $Q_{1 \to 2, \text{init}}$ correspond à la charge Q échangée entre les deux tensions à vide $COV_1$ et $COV_2$ dans un état initial du dispositif pour lequel l'état de santé est considéré être maximal.

L'état de santé quantifie la perte de capacité du dispositif par rapport à sa capacité initiale (à l'état neuf, non dégradé). En première approximation et d'un point de vue géométrique, la réduction de capacité entraine une compression de la courbe caractéristique selon l'axe des abscisses (voir [Fig. 5]). Autrement dit, entre deux niveaux de tension à vide $V_{oc,1}$ et $V_{oc,2}$, le vieillissement du dispositif se traduit par une diminution de la charge échangée $Q_{1 \to 2}$. Cela explique que, pour obtenir une estimation de l'état de santé, connaitre deux niveaux de tension à vide $V_{oc,1}$ et $V_{oc,2}$ permet de déduire la charge échangée par le dispositif dans son état initial et la charge échangée par le dispositif entre ces deux mêmes niveaux dans l'état dégradé que l'on cherche à quantifier.

La charge échangée entre deux états peut être calculée par une opération 107 de comptage coulombique direct à partir de séries temporelles à condition que les tensions correspondent bien à des tensions à vide, c'est-à-dire sans charge et après une période de repos suffisamment longue. La combinaison avec le premier ensemble d'opérations permet donc avantageusement de lire directement une caractéristique de tension à vide sans qu'il soit nécessaire d'imposer des phases de repos et donc sans qu'il soit nécessaire d'interrompre le fonctionnement opérationnel du dispositif. Autrement dit, le premier ensemble d'opérations permet de se dispenser de l'opération 107 pour mettre en oeuvre l'opération 108. Néanmoins, l'opération 107 peut aussi être mise en oeuvre en plus du premier ensemble d'opérations 101 à 106.

Dans les opérations 109 et 110, alternatives aux opérations 107 et 108, on suppose disposer d'autres courbes de tension à vide (ou de données permettant indirectement de les obtenir). De telles courbes peuvent résulter d'essais classiques autres que le premier ensemble des opérations 101 à 106. Par exemple, elles sont préalablement obtenues par des essais de vieillissement accéléré, des mesures d'état de santé sur le terrain, etc. Dans une telle situation, l'état de santé du dispositif étudié à l'instant présent peut être déduit par correspondance d'au moins une courbe de tension à vide à disposition et de la courbe de tension à vide obtenue à l'issue du premier ensemble d'opération 101 à 106. Autrement dit, la courbe de tension à vide obtenue est confrontée à une table de correspondance préexistante.

Dans une opération 109, les tensions à vide obtenues à l'issu du premier ensemble d'opérations 101 à 106 sont soumises à une analyse de capacité incrémentielle (ou ICA pour « *Incremental Capacity Analysis* »). Brièvement, si g est la fonction telle que $Q = g(V_{oc})$, alors l'ICA est l'étude de la dérivée de la fonction g. On obtient ainsi une courbe à motifs caractéristiques.

Ici, la correspondance se base sur l'étude de la dérivée de la courbe de tension à vide, plutôt que sur l'étude de la charge échangée entre deux états caractérisés par leurs tensions à vide (i.e. examiner la pente moyenne de la courbe de tension à vide entre ces tensions). La [Fig. 6] représente graphiquement cette opération. La partie haute représente une courbe de tension à vide tandis que la partie basse représente une courbe d'ICA correspondante.

Diverses méthodes d'ICA sont connues en tant que telles. Dans l'exemple décrit ici, pour estimer l'état de santé, on privilégie l'analyse de l'évolution des motifs caractéristiques de la courbe d'ICA au fil de la dégradation du dispositif (apparition, disparition, déplacements de pics, vallées, aires, etc.). La quantification de l'état de santé à partir de ces motifs, et surtout de leur évolution, requiert une campagne préalable d'essais préliminaires afin d'établir une correspondance entre les motifs et le niveau de santé.

Ensuite, dans une opération 110, la courbe obtenue (la dérivée) est comparée à des courbes de référence correspondant à divers états de santé afin d'identifier l'état de santé par correspondance.

Dans de nombreux cas, la courbe de tension à vide obtenue à l'issue du premier ensemble d'opération 101 à 106 est bruitée. En effet, l'estimation de $V_{oc}$ groupe par groupe (ou tranche par tranche) rend la courbe d'OCV bruitée. Aussi, préalablement à l'application de l'ICA, une étape intermédiaire de post-traitement de la courbe de tension à vide est préférable Par exemple, un lissage et/ou un filtrage est recommandé.

Le premier ensemble d'opération 101 à 106 (ou 101 à 105) peut être mis en oeuvre de manière itérative. Par exemple, il peut être mis en oeuvre sensiblement en temps réel lorsque les mesures de chaque instant sont disponibles en temps réel. La mise en oeuvre itérative permet en outre d'affiner la précision, par exemple en calculant simultanément l'erreur et en réitérant le premier ensemble d'opérations lorsque l'erreur reste supérieure à un seuil prédéfini.

En outre, parallèlement à l'opération 102 d'application de la fonction de correction $\alpha$, une opération 111 peut être mise en oeuvre, par exemple en temps réel.

L'opération 111, qui peut aussi être vue comme faisant partie de l'opération 102, comprend le calcul d'un état de charge (SOC) selon la formule suivante :

[Math. 8]

$$SOC_i = SOC_{i-1} + \frac{\int_{i-1}^{i} \alpha(I_i)\, dt}{Q_{max,i}} = SOC_{i-1} + \frac{\int_{i-1}^{i} I_{corr}\, dt}{Q_{max,i}}$$

L'indice i représente l'itération et $\alpha$ la fonction de correction.

Ainsi, l'opération 111 correspond à l'application de la fonction de correction du courant pour le calcul du SOC en temps réel. Si le courant traversant le dispositif étudié est utilisé directement en tant que données d'entrée (sans correction) une dérive du comptage coulombique apparait. Par exemple, un dispositif ayant un rendement en charge électrique de 98% signifie que, sur un cycle de charge-décharge complet, seul 98% de la charge électrique est déchargée. Un comptage coulombique direct (sans correction) indiquerait alors un SOC de 2% à l'issu de la décharge alors que cet élément serait complètement déchargé, ce qui est évidemment incorrect.

La fonction de correction, ajustée au cours de l'opération 102, permet donc de fiabiliser le calcul du SOC du dispositif. La fonction de correction $\alpha$ est mise à jour à chaque exécution de l'opération 111, donc à chaque itération. Le calcul cumulatif est donc conforme à la formule [Math. 8] ci-avant.

Comme le laisse apparaitre la formule, le comptage coulombique nécessite la connaissance d'un niveau initial en termes de SOC ou de Q. Cette référence peut être prise :

- à partir d'instants où le SOC est explicite, tels que des états complètement chargés ou complètement déchargés du dispositif ;
- dans un état de charge intermédiaire, lorsque le dispositif est au repos depuis une durée suffisante. La tension mesurée est alors la tension à vide $V_{oc}$ et le SOC peut être établi à partir de la carte OCV-Q établie à l'issue du premier ensemble d'opérations 101-106.
- dans un état de charge intermédiaire lorsque le système est en opération, comme cela est décrit ci-après relativement à l'opération 112.

En outre, ces trois options peuvent aussi être utilisées pour effectuer un ré-étalonnement du comptage coulombique.

Parallèlement à l'opération 105 de calcul de tension à vide par groupe, une opération 112 peut être mise en oeuvre, par exemple en temps réel.

L'opération 112, qui peut aussi être vue comme faisant partie de l'opération 105, comprend une comparaison des tensions à vide calculées à des courbes de correspondance entre tensions à vide et état de charge (COV) afin d'identifier l'état de charge par correspondance.

L'opération 112 met en oeuvre le modèle équivalent calculé lors du premier ensemble d'opérations 101 à 106, chacun des paramètres constitutifs du modèle équivalent étant connu et ajusté à l'état courant du dispositif. Ainsi, on traduit des mesures en courant et tension, en une tension à vide. De plus, à l'issu du premier ensemble d'opérations 101 à 106, une carte OCV-Q est établie. Il résulte donc un lien de correspondance entre la tension, le courant et le SOC. Ainsi, à chaque instant t, $V_{oc}$ est calculé grâce au modèle entièrement déterminé puis converti en une valeur de SOC grâce à la carte OCV-Q.

Les procédés et les variantes décrites ci-avant peuvent être mis en oeuvre par des moyens informatiques, notamment un ordinateur sur lequel est enregistré un programme pour la mise en oeuvre d'un tel procédé lorsque ce programme est exécuté par un processeur. Un tel programme peut aussi être stocké sur un support d'enregistrement non transitoire lisible par un ordinateur.

Les solutions proposées permettent une estimation de l'état de santé (SOH) et de l'état de charge (SOC) d'un dispositif à partir de données brutes en opération. Dans un premier temps, la courbe de tension à vide (OCV) en fonction de la charge (Q) est obtenue par un comptage coulombique suivie d'un calcul d'optimisation sur modèle équivalent. La courbe $V_{oc} = f(Q)$ ainsi obtenue peut alors être utilisée pour déterminer l'état de santé d'un dispositif par comptage coulombique entre états ou par l'étude plus généralisée de sa forme. L'état de charge en temps réel peut être estimé par comptage coulombique corrigé ou par évaluation d'un modèle équivalent. La fonction de correction, tout comme le modèle, sont des résultats intermédiaires dans le processus de l'obtention de la courbe d'OCV.

La présente divulgation pour le calcul du SOH et du SOC d'un dispositif en fonctionnement par l'intermédiaire de l'estimation de sa caractéristique OCV, se différencie des techniques connues notamment par :

- l'utilisation de tranches d'état en tant que fenêtres de calcul. L'état de l'art propose seulement des méthodes ayant une fenêtre temporelle (un ou plusieurs pas de temps consécutifs). Ceci donne l'avantage de profiter de la diversité des points de mesure au sein d'une tranche pour obtenir un résultat plus fiable car issu d'un échantillon plus riche.
- l'utilisation de multiples états non consécutifs dans le temps. Conséquence du point précédent.
- une quantification de l'incertitude/erreur liée à l'estimation de la courbe caractéristique d'OCV. Ceci donne le double avantage de juger de la fiabilité du résultat obtenu et de servir de variable de vérification.
- l'utilisation d'une fonction de correction du courant pour toutes les applications nécessitant un comptage coulombique. Ceci donne l'avantage de réaliser un comptage coulombique plus précis.
- l'ajustement de la fonction de correction grâce à l'erreur de la courbe d'OCV plutôt que par d'autres variables brutes telles que la tension ou le SOC théorique fournis par le fabricant, mais non spécifique au dispositif réel considéré.
- l'application de modèles équivalents intégrés dans des fonctions d'optimisation/minimisation tandis que la littérature présente seulement des modèles équivalents utilisés isolément.
- la non-utilisation de la variable SOC fournie par le fabricant pour le calcul du SOH. Ceci donne l'avantage de ne pas dépendre de la fiabilité de cet indicateur.
- la possibilité de se passer des cartes $V_{oc}$-SOC en amont de l'utilisation de la batterie puisque celles-ci sont produites lors de la phase d'utilisation. Ceci donne l'avantage de se passer de couteuses campagnes d'essai.

En conséquence, les solutions proposées permettent généralement de :

- lever la contrainte des profils de sollicitation spécifiques. De nombreuses méthodes connues proposent une estimation de l'état de santé à partir des données de courant et tension. Cependant, elles nécessitent des profils de sollicitation particuliers (cycle complet, profil avec des périodes de repos, limites en courant et tension, etc.). Elles ne peuvent pas être appliquées à partir de données issues d'un profil de sollicitation quelconque. La solution proposée est quant à elle applicable sur tout type de profil.
- lever la contrainte de calculs algorithmiques lourds et couteux en ressources de calcul et en temps. Le calcul d'optimisation est linéaire et donc peu couteux.
- lever la contrainte de continuité de mesure pour les modèles de vieillissements. Contrairement aux modèles de vieillissements cumulatifs qui nécessitent un calcul continu de la dégradation depuis un état de dégradation connu, cette solution peut être déployée directement sur une période courte (heures, jours) sans connaissance de l'historique du système.
- donner accès aux techniques de laboratoire pour l'estimation du SOH. La courbe d'OCV étant généralement obtenue en conditions de laboratoire, le premier ensemble d'opérations permet de convertir des données opérationnelles brutes en une forme exploitable par des techniques de laboratoire.
- d'apporter une alternative aux indicateurs SOC et SOH calculés par le fabricant.

On notera que la boucle itérative entre les opérations 106 et 102 permettant de trouver la meilleure fonction de correction du courant peut être supprimée. Le procédé peut donc être basé sur une fonction de correction prédéfinie ou évolutive.

L'opération 104 peut intégrer une détection des occurrences. Une occurrence est ici définie comme un ensemble de pas de temps consécutifs à l'intérieur d'un groupe (ou tranche) de capacité. Au cours de l'opération 105 ces occurrences peuvent subir des traitements spécifiques, par exemple être converties en moyenne ou être filtrées (valeur absolue du courant, sa dérivée, en fonction de la température, etc.).

L'opération 105 peut inclure des modèles d'ordre supérieur à celui décrit ci-avant, c'est-à-dire faisant apparaitre des dérivées temporelles. Les paramètres liés aux termes en dérivée temporelle peuvent être calculés ou imposés.

Le procédé peut inclure, ou non, la mesure des données d'entrée elle-même. On distingue deux manières de mettre en oeuvre le procédé :

- Pour des applications en temps réel (stockage stationnaire ou embarqué au dispositif). La méthode algorithmique peut se voir intégrée dans le système de gestion du dispositif (ou BMS pour « *Battery Management System* »). Les données brutes suffisantes correspondent alors aux instants ($t_0$, $t_0 - \Delta t$, ..., $t_0 - n*\Delta t$). Le premier ensemble des opérations 101 à 106 peut être exécuté en continu sur une fenêtre glissante, ou de manière périodique. Le calcul du SOH peut se faire à chaque exécution (itération) du premier ensemble. Le calcul du SOC peut s'effectuer en continu avec une mise à jour des paramètres à chaque itération du premier ensemble. Le procédé utilise ensuite les indicateurs calculés en local, ou peut les exporter.
- Pour des applications d'analyse *a posteriori* (stockage d'énergie stationnaire ou embarqué). La méthode algorithmique peut être déportée du dispositif lui-même, par exemple intégrée à un outil de traitement de données plus général dans lequel une partie ou la totalité des données collectées est traitée.

En fonction des applications, les résultats obtenus peuvent être classés en résultats finaux ou intermédiaires. Une estimation au moins partielle de la courbe d'OCV après chaque exécution du premier ensemble d'opérations 101 à 106 peut généralement être considérée comme un résultat final. Il en est de même pour une estimation du SOH après chaque itération suivie des étapes 107, 108, 109 et/ou 110, ainsi que pour une estimation du SOC à chaque pas de temps. Une fonction de correction du courant ajustée pour le comptage coulombique ainsi qu'une estimation de la résistance interne et d'autres paramètres constituant le modèle équivalent pour chaque groupe (ou tranche) de charge peuvent être considérées comme des résultats intermédiaires.

Dans les deux cas, les valeurs de SOH et de SOC, ainsi que les courbes d'OCV obtenues, peuvent être comparées aux résultats calculés par les procédés connus et implémentés dans le Système de Gestion de Batterie (BMS) et aux valeurs mesurées lors de tests.

La redondance dans le calcul des procédés décrits ici permet d'obtenir des indicateurs plus précis et donc d'effectuer un pilotage plus fiable des dispositifs électrochimiques de stockage d'énergie. La fiabilité générale des systèmes s'en trouve améliorée. Leur durée de vie peut être augmentée par un pilotage mieux adapté.

L'estimation des indicateurs se fait sans modification du comportement du dispositif. La valeur de service du dispositif n'est donc pas impactée par de tels procédés. Aucun outillage ou équipement supplémentaire n'est nécessaire (sondes, capteurs). Seules les grandeurs physiques de base telles que la tension, le courant et la température sont utilisés. Or ces propriétés sont usuellement mesurées et disponibles dans les systèmes existants.

Enfin, aucune campagne d'essai n'est nécessaire en amont (pour évaluer le vieillissement du système en testant de manière extensive certains échantillons). Aucune campagne d'essai n'est nécessaire en aval de la phase d'utilisation (analyses *post mortem*).

La présente divulgation ne se limite pas aux exemples de valeurs et modèles d'estimation utilisés dans le cadre des procédé, programme et support d'enregistrement décrits ci-avant, seulement à titre d'exemple, mais elle englobe toutes les variantes que pourra envisager la personne du métier dans le cadre de la protection recherchée.

**Liste des signes de référence**

**[0082]** - 101 à 112 : Opération

**Revendications**

1. Procédé de détermination d'une tension à vide d'un dispositif électrochimique, mis en oeuvre par des moyens informatiques, comprenant :

   a. collecter (101) des données de mesures du dispositif, lesdites mesures

      i. incluant au moins le courant $I_t$ et la tension $U_t$ aux bornes du dispositif,

ii. étant horodatées, et
iii. étant acquises aux cours d'une période de fonctionnement opérationnel et ininterrompue du dispositif ;

b. calculer, pour une pluralité d'instants t,

iv. une intensité corrigée $I_{cor,t}$ (102) par l'application d'une fonction de correction à l'intensité mesurée $I_t$, et
v. une charge instantanée $Q_t$ (103) à partir d'une série temporelle de l'intensité corrigée $I_{cor}$

de manière à obtenir, pour chaque instant t, un jeu de données collectées et calculées $I_t$, $U_t$, $I_{cor,t}$, $Q_t$ ;
c. grouper (104) les jeux de données par plages de valeurs de charge instantanée en fonction de ladite valeur de charge de chaque jeu ;
d. pour chaque groupe distinctement, calculer (105) une tension à vide du dispositif.

2. Procédé selon la revendication précédente, comprenant en outre, après le calcul des tensions à vide :
e. calculer (108) un état de santé du dispositif selon la formule suivante :

[Math. 7]

$$SOH = \frac{Q_{1 \rightarrow 2,ag\acute{e}}}{Q_{1 \rightarrow 2,init}}$$

dans laquelle $Q_{1 \rightarrow 2,ag\acute{e}}$ correspond à la différence de charge Q entre deux jeux de données correspondant à deux tensions à vide $COV_1$ et $COV_2$ et dans laquelle $Q_{1 \rightarrow 2,init}$ correspond à la charge Q échangée entre les deux tensions à vide $COV_1$ et $COV_2$ dans un état initial du dispositif pour lequel l'état de santé est considéré être maximal.

3. Procédé selon l'une des revendications précédentes, comprenant en outre, après le calcul des tensions à vide :

f. soumettre (109) les tensions à vide calculées à une analyse de capacité incrémentielle (ICA) de manière à obtenir une courbe à motifs caractéristiques ;
g. comparer (110) la courbe obtenue à des courbes de référence correspondant à divers états de santé afin d'identifier l'état de santé par correspondance.

4. Procédé selon l'une des revendications précédentes, dans lequel l'étape de calcul est mise en oeuvre de manière itérative à chaque instant t et dans lequel le calcul de la charge instantané $Q_t$ à partir d'une série temporelle de l'intensité corrigée $I_{cor}$ est mis en oeuvre selon la formule suivante :

[Math. 3]

$$Q(t) = Q(t = t_0) + \int_{t_0}^{t} I_{corr}(\tau) \, d\tau$$

dans laquelle $Q(t=t_0)$ est un niveau de charge relatif au niveau de charge initial.

5. Procédé selon la revendication précédente, dans lequel l'étape de calcul comprend en outre :
vi. calculer (111) un état de charge (SOC) selon la formule suivante :

[Math. 8]

$$SOC_i = SOC_{i-1} + \frac{\int_{i-1}^{i} \alpha(I_i) \, dt}{Q_{max,i}} = SOC_{i-1} + \frac{\int_{i-1}^{i} I_{corr} \, dt}{Q_{max,i}}$$

où l'indice i représente l'itération et $\alpha$ la fonction de correction.

**6.** Procédé selon l'une des revendications précédentes, comprenant en outre, après le calcul des tensions à vide :
h. comparer (112) les tensions à vide calculées à des courbes de correspondance entre tensions à vide et état de charge afin d'identifier l'état de charge par correspondance.

**7.** Procédé selon l'une des revendications précédentes, comprenant en outre, après le calcul des tensions à vide, un calcul d'état de santé du dispositif par l'une au moins des opérations suivantes :

- comparaison des tensions à vide obtenues avec des tensions à vide obtenues par des essais d'une pluralité de vieillissements en laboratoire sur ledit dispositif ;
- comparaison des tensions à vide obtenues avec des tensions à vide obtenues par des essais d'une pluralité de vieillissements en laboratoire sur un dispositif de modèle similaire audit dispositif ;
- comparaison des tensions à vide obtenues avec des tensions à vide obtenues par une mise en oeuvre antérieure du procédé selon la revendication 1 sur ledit dispositif.

**8.** Programme informatique comportant des instructions pour la mise en oeuvre du procédé selon l'une des revendications 1 à 7 lorsque ce programme est exécuté par un processeur.

**9.** Support d'enregistrement non transitoire lisible par un ordinateur sur lequel est enregistré un programme pour la mise en oeuvre du procédé selon l'une des revendications 1 à 7 lorsque ce programme est exécuté par un processeur.

**Patentansprüche**

**1.** Verfahren zum Bestimmen einer Leerlaufspannung einer elektrochemischen Vorrichtung, welches durch Computermittel ausgeführt wird, umfassend:

a. Sammeln (101) von Messdaten der Vorrichtung, wobei die Daten

i. wenigstens den Strom $I_t$ und die Spannung $U_t$ an den Anschlüssen der Vorrichtung umfassen,
ii. zeitdatiert sind, und
iii. während einer Zeitperiode eines betriebsmäßigen und ununterbrochenen Arbeitens der Vorrichtung aufgenommen werden;

b. Berechnen für eine Mehrzahl von Zeitpunkten t

iv. einer korrigierten Intensität $I_{cor,t}$ (102) durch das Anwenden einer Korrekturfunktion auf die gemessene Intensität $I_t$, und
v. einer momentanen Ladung $Q_t$ (103) ausgehend von einer Zeitserie der korrigierten Intensität $I_{cor}$

um für jeden Zeitpunkt t einen Satz von gesammelten und berechneten Daten $I_t$, $U_t$, $I_{cor,t}$, $Q_t$ zu erhalten;
c. Gruppieren (104) der Sätze von Daten nach Wertebereichen der momentanen Ladung als Funktion des Werts der Ladung von jedem Satz;
d. für jede Gruppe einzeln Berechnen (105) einer Leerlaufspannung der Vorrichtung.

**2.** Verfahren nach dem vorhergehenden Anspruch, ferner umfassend nach dem Berechnen der Leerlaufspannungen:
e. Berechnen (108) eines Gesundheitszustands der Vorrichtung gemäß der folgenden Formel:

[Math. 7]

$$SOH = \frac{Q_{1\rightarrow2,agé}}{Q_{1\rightarrow2,init}}$$

wobei $Q_{1\rightarrow2,agé}$ der Differenz der Ladung Q zwischen zwei Sätzen von Daten entspricht, welche zwei Leerlaufspannungen $COV_1$ und $COV_2$ entsprechen, und wobei $Q_{1\rightarrow2,init}$ der Ladung Q entspricht, welche zwischen den beiden Leerlaufspannungen $COV_1$ und $COV_2$ in einem anfänglichen Zustand der Vorrichtung ausgetauscht wird, für welche der Gesundheitszustand als maximal angenommen wird.

3. Vorrichtung nach einem der vorhergehenden Ansprüche, ferner umfassend nach dem Berechnen der Leerlaufspannungen:

    f. Unterziehen (109) der berechneten Leerlaufspannungen einer inkrementellen Kapazitätsanalyse (ICA), um eine Kurve mit charakteristischen Mustern zu erhalten;
    g. Vergleichen (110) der erhaltenen Kurve mit Referenzkurven, welche verschiedenen Gesundheitszuständen entsprechen, um durch Abgleich den Gesundheitszustand zu identifizieren.

4. Verfahren nach einem der vorhergehenden Ansprüche, wobei der Schritt des Berechnens in iterativer Weise bei jedem Zeitpunkt t ausgeführt wird und wobei die Berechnung der momentanen Ladung $Q_t$ ausgehend von einer Zeitserie der korrigierten Intensität $I_{cor}$ gemäß der folgenden Formal ausgeführt wird:

[Math. 3]

$$Q(t) = Q(t = t_0) + \int_{t_0}^{t} I_{corr}(\tau)d\tau$$

wobei Q(t=t₀) ein Ladungspegel relativ zu dem anfänglichen Ladungspegel ist.

5. Verfahren nach dem vorhergehenden Anspruch, wobei der Schritt des Berechnens ferner umfasst:
vi. Berechnen (111) eines Ladungszustands (SOC) gemäß der folgenden Formel:

[Math. 8]

$$SOC_i = SOC_{i-1} + \frac{\int_{i-1}^{i} \alpha(I_i)dt}{Q_{max,i}} = SOC_{i-1} + \frac{\int_{i-1}^{i} I_{corr}dt}{Q_{max,i}}$$

wobei der Index i die Iteration und $\alpha$ die Korrekturfunktion repräsentiert.

6. Verfahren nach einem der vorhergehenden Ansprüche, ferner umfassend nach dem Berechnen der Leerlaufspannungen:
h. Vergleichen (112) der berechneten Leerlaufspannungen mit Korrespondenzkurven zwischen Leerlaufspannungen und dem Ladungszustand, um den Ladungszustand durch Abgleich zu identifizieren.

7. Verfahren nach einem der vorhergehenden Ansprüche, ferner umfassend nach dem Berechnen der Leerlaufspannungen, ein Berechnen eines Gesundheitszustands der Vorrichtung durch wenigstens einen der folgenden Vorgänge:

    - Vergleichen der erhaltenen Leerlaufspannungen mit Leerlaufspannungen, welche durch Versuche mit einer Mehrzahl von Alterungsvorgängen im Labor auf die Vorrichtung erhalten werden;
    - Vergleichen der erhaltenen Leeraufspannungen mit Leerlaufspannungen, welche durch Versuche einer Mehrzahl von Alterungsvorgängen im Labor auf eine Modellvorrichtung erhalten werden, welche der Vorrichtung ähnlich ist;
    - Vergleichen der erhaltenen Leerlaufspannungen mit Leerlaufspannungen, welche durch ein vorheriges Ausführen des Verfahrens nach Anspruch 1 auf die Vorrichtung erhalten werden.

8. Computerprogramm, umfassend Anweisungen zum Ausführen des Verfahrens nach einem der Ansprüche 1 bis 7, wenn dieses Programm von einem Prozessor ausgeführt wird.

9. Nichtflüchtiger Datenträger, welcher von einem Computer lesbar ist, auf welchem ein Programm zum Ausführen des Verfahrens nach einem der Ansprüche 1 bis 7 gespeichert ist, wenn das Programm von einem Prozessor ausgeführt wird.

**Claims**

1.  Method for determining an open circuit voltage of an electrochemical device, implemented by computer means, comprising:

    a. collecting (101) measurement data of the device, said measurements

    i. including at least the current $I_t$ and the voltage $U_t$ at the terminals of the device,
    ii. being time-stamped, and
    iii. being acquired during an uninterrupted and operational functional period of the device;

    b. calculating, for a plurality of times t,

    iv. a corrected intensity $I_{cor,t}$ (102) by applying a correction function to the measured intensity $I_t$, and
    v. an instantaneous charge $Q_t$ (103) based on a time series of the corrected intensity $I_{cor}$

    so as to obtain, for each time t, a set of collected and calculated data $I_t$, $U_t$, $I_{cor,t}$, $Q_t$;
    c. grouping (104) the data sets into ranges of instantaneous charge values based on said charge value of each set;
    d. separately for each group, calculating (105) an open circuit voltage of the device.

2.  Method according to the preceding claim, further comprising, after calculating the open circuit voltages:
    e. calculating (108) a state of health of the device according to the following formula:

    [Math. 7]

    $$SOH = \frac{Q_{1\rightarrow2,agé}}{Q_{1\rightarrow2,init}}$$

    where $Q_{1\rightarrow2,agé}$ corresponds to the charge difference Q between two data sets corresponding to two open circuit voltages $COV_1$ and $COV_2$ and where $Q_{1\rightarrow2,init}$ corresponds to the charge Q exchanged between the two open circuit voltages $COV_1$ and $COV_2$ in an initial state of the device for which the state of health is considered to be maximal.

3.  Method according to one of the preceding claims, further comprising, after calculating the open circuit voltages:

    f. subjecting (109) the calculated open circuit voltages to an incremental capacity analysis (ICA) so as to obtain a curve of characteristic patterns;
    g. comparing (110) the obtained curve to reference curves corresponding to various states of health in order to identify the corresponding state of health.

4.  Method according to one of the preceding claims, wherein the calculation step is carried out iteratively at each time t and wherein the calculation of the instantaneous charge $Q_t$ based on a time series of the corrected intensity $I_{cor}$ is implemented according to the following formula:

    [Math. 3]

    $$Q(t) = Q(t = t_0) + \int_{t_0}^{t} I_{corr}(\tau)\, d\tau$$

    where $Q(t=t_0)$ is a charge level relative to the initial charge level.

5.  Method according to the preceding claim, wherein the calculation step further comprises:
    vi. calculating (111) a state of charge (SOC) according to the following formula:

[Math. 8]

$$SOC_i = SOC_{i-1} + \frac{\int_{i-1}^{i} \alpha(I_i)\, dt}{Q_{max,i}} = SOC_{i-1} + \frac{\int_{i-1}^{i} I_{corr}\, dt}{Q_{max,i}}$$

where the index i represents the iteration and $\alpha$ the correction function.

6.  Method according to one of the preceding claims, further comprising, after calculating the open circuit voltages:
    h. comparing (112) the calculated open circuit voltages to curves of correspondence between open circuit voltages and state of charge in order to identify the corresponding state of charge.

7.  Method according to one of the preceding claims, further comprising, after calculating the open circuit voltages, calculating the state of health of the device by at least one of the following operations:

    - comparing the obtained open circuit voltages to the open circuit voltages obtained by a plurality of laboratory aging tests on said device;
    - comparing the obtained open circuit voltages to the open circuit voltages obtained by a plurality of laboratory aging tests on a device of a model similar to said device;
    - comparing the obtained open circuit voltages to the open circuit voltages obtained by a previous implementation of the method according to claim 1 on said device.

8.  Computer program comprising instructions for implementing the method according to one of claims 1 to 7 when this program is executed by a processor.

9.  Non-transitory computer-readable storage medium on which is stored a program for implementing the method according to one of claims 1 to 7 when this program is executed by a processor.

[Fig. 1]

# Fig. 1

[Fig. 2]

**Fig. 2**

[Fig. 3]

## Fig. 3

[Fig. 4]

Fig. 4

[Fig. 5]

Fig. 5

U(V)

[Fig. 6]

Fig. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2019025171 A
- WO 2015133103 A
- WO 2013111231 A
- WO 2015186283 A
- FR 3003038
- WO 20111555184 A
- US 2018050681 A1